# EUROPEAN PATENT APPLICATION

(11) **EP 4 572 032 A1**
(43) Date of publication of application: **18.06.2025**
(21) Application number: 23216495.4
(22) Date of filing: 14.12.2023
(51) Int. Cl.: H01R 13/53, H01R 13/66

(54) **SENSOR ASSEMBLY FOR A SWITCHGEAR CONNECTOR**

(71) Applicant: TE Connectivity Solutions GmbH, 8200 Schaffhausen (CH); Tyco Electronics UK Ltd, Wiltshire SN3 5HH (GB)
(72) Inventor: WINTER, Axel, 8200 Schaffhausen (CH); BIAGINI, Veronica, 8200 Schaffhausen (CH); ROBERTS, Jonathan, Swindon, SN3 5HH (GB); WISEMAN, Stephen John, Swindon, SN3 5HH (GB)
(74) Representative: Grünecker Patent- und Rechtsanwälte PartG mbB

(57) **Abstract**

Sensor assembly (26) for a switchgear connector (1), the sensor assembly (26) comprising: a high voltage side (28) facing the switchgear; a low voltage side (30); an isolation barrier (32) that provides a galvanic isolation between the high voltage side (28) and the low voltage side (30); a sensor device (34) configured to measure at least one physical quantity and a sensor data output device representative of the at least one physical quantity, the sensor device (34) being arranged on the high voltage side (28); a data interface (36) arranged on the low voltage side (30) and configured to provide for the sensor device data (40) to be accessible from outside of the sensor assembly (26); and a transmission path (42) which is configured to transfer sensor device data (40) between the sensor device (34) and the output interface (36); wherein the transmission path (42) comprises a wireless section which extends across the isolation barrier (32).

## Description

The invention relates to a sensor assembly for a switchgear connector, a back plug for a switchgear connector containing part of the sensor assembly and a set for a switchgear connector comprising the back plug and a sensor unit.

Switchgear connectors are often used in medium and high voltage applications to connect switch-gears, transformers. They are used in outdoor power distribution systems and/or indoor applications like in substations, and required to perform under ambient conditions, which in some cases may be extreme. A reliable performance of these connectors is critical to ensure proper functioning of the electrical systems.

Therefore, there is a need for switchgear connectors that perform reliably.

This need is addressed by a sensor assembly for a switchgear connector, the sensor assembly comprising a high voltage side facing the switchgear; a low voltage side; an isolation barrier that provides a galvanic isolation between the high voltage side and the low voltage side; a sensor device configured to measure at least one physical quantity and a sensor data output device representative of the at least one physical quantity, the sensor device being arranged on the high voltage side; a data interface arranged on the low voltage side and configured to provide for the sensor device data to be accessible from outside of the sensor assembly; and a transmission path which is configured to transfer sensor device data between the sensor device and the output interface, wherein the transmission path comprises a wireless section which extends across the isolation barrier.

The need is further addressed by providing a back plug for a switchgear connector containing the low voltage side and the isolation barrier of the sensor assembly mentioned above and a set for a switchgear connector comprising the aforementioned back plug and a sensor unit configured to be mounted on a switchgear lug on the high voltage side.

Finally, the need is addressed by a switchgear connector comprising the back plug or the set mentioned above.

The above solutions are advantageous, as they facilitate monitoring the condition of switchgear connectors for protective and maintenance purposes and help avoid fatal faults and damages during operation and maintenance. Thus, a sudden and unexpected failure of the switchgear connectors can be avoided and the switchgear connectors perform more reliably.

Moreover, the solutions may be used to retrofit existing switchgear connectors. Thus they can be used to modernise existing switchgear installations, so that they can be used more efficiently and more reliably in smart power systems.

The invention can be further improved by the following embodiments which are advantageous in themselves and which can be arbitrarily combined with one another.

The data interface of the sensor assembly can be analog and/or digital. Having an analog data interface has the advantage of a low latency and an easy integration with sensors measuring data of the physical world, since many natural phenomena are continuous and analog. A digital data interface on the other hand is less susceptible to noise or interferences and allows for more flexibility. The combination of both combines both advantages and is more versatile, especially in retrofit situations.

The sensor device data can be transmitted via wire, which provides higher speeds and a reliable transmission and is easy to set up. The sensor device data can be transmitted wirelessly, which reduces clutter, is quick and easy to install and allows for flexible and scalable set-ups.

The data interface can be a bus system, especially a standardised bus system. The bus system can comprise a fieldbus, Ethernet or Bluetooth. Bus systems are simple and cost-effective to implement and have the advantage of uniformity, since the bus protocols and the unified connection technology and equipment are standardised, making expansions and changes easy and the system highly adjustable. Further, bus systems are easily scalable so that the number and type of devices attached to the bus systems may vary or be changed. The data interface may further provide wires and/or connectors. The data interface may be an in- and output interface, providing means to input sensor data as well as means to provide information or feedback to the user.

The transmission path may be configured to provide unidirectional data transmission from the sensor device data to the data interface, which is often used in real time monitoring or to secure the data transmission. The transmission path may also be configured to provide bidirectional data transmission between the data interface and the sensor device, transmitting data in both directions and able to send and receive, contributing to more efficiency in the data transfer. Using data transmission from the data interface to the sensor device allows e.g. programming of the sensor device or the altering of parameters.

The sensor device may include a temperature sensor which is configured to measure temperature. It may especially be configured to measure the temperature within the switchgear connector to monitor if the maximum temperature threshold of the connector is exceeded at any time.

The sensor device may include at least one magnetic field sensor which is configured to measure a magnetic field generated by the switchgear. The at least one magnetic field sensor can be used to measure the current within the connector and to monitor it.

The sensor device can include a capacitive voltage sensor. The capacitive voltage sensor can be an active capacitive sensor. The capacitive voltage sensor can also include a primary and secondary capacitor. The primary and secondary capacitor can be made from the same material to have a higher accuracy over a wider temperature range. The capacitive voltage sensor can be temperature-compensated and can include a reference capacitor made of the same material as the primary capacitor to reduce the effect of temperature fluctuations on the components of the sensor.

The primary capacitor can be located on the high voltage side, while the secondary capacitor can be located on the low voltage side. The isolation barrier is then located between the primary capacitor and the secondary capacitor. The isolation barrier can also be part of the primary capacitor. The reference capacitor is located on the low voltage side.

The sensor device can include a microcontroller configured to perform a temperature correction depending on the sensor device data from the temperature sensor representing temperature.

The sensor device may comprise a humidity sensor. The humidity sensor can be configured to measure ambient humidity. It can also be configured to measure humidity within the back plug or within the switchgear connector, which can prove important to monitor, since condensation on a part increases the risk of corrosion and failure.

The sensor device may comprise a line frequency sensor. As the frequency of an electrical system varies, for example when load and generation of power change, monitoring the line frequency proves useful to take protective steps, i.e. targeted switching-off of components of a network when a decline of frequency is sensed.

The sensor device may further comprise a partial discharge sensor. Partial discharge often occurs within a solid insulation system and is not visible to the eye. Every partial discharge will degrade the component, such as the insulating material, further, increasing the risk of a cable system failure, making the monitoring of occurrences of partial discharges in connectors very beneficial in preventing such failures and elongating the operating life of the individual components.

The sensor device may comprise an air pressure sensor, which can be another preventive measure when identifying deviations of pressure within the connector.

The sensor assembly may comprise a humidity sensor and/or a line frequency sensor and/or a partial discharge sensor and/or an air pressure sensor. The air pressure sensor and/or the humidity sensor, as well as any other type of sensor measuring ambient conditions, may be located on the low voltage side. The transmission path may include any of the sensors, connecting any of the sensors to the data interface.

Another advantageous embodiment of the sensor assembly comprises a sensor subassembly, wherein the sensor subassembly comprises a first sensor component on the high voltage side and the second sensor component on the low voltage side. The first and the second sensor component are configured to cooperatively measure at least one further physical quantity across the isolation barrier. The second sensor component can be connected to the transmission path and configured to output sensor data representative of the at least one further physical quantity. This embodiment may prove useful when utilising a sensor with an active and a passive part or one that requires both a high voltage and a low voltage.

The at least one further physical quantity can be different from the at least one physical quantity measured by the sensor device, thus allowing for the measurement of at least two different physical quantities within one switchgear connector for a versatile sensor being able to monitor multiple physical quantities within a connector.

The sensor subassembly can comprise a capacitor, the first sensor component comprising a first conductor of the capacitor, the second sensor component comprising a second conductor of the capacitor, the isolation barrier separating the first from the second conductor. This set-up may be used to measure voltages.

The sensor subassembly can include a capacitive voltage sensor. The capacitive voltage sensor is an active capacitive voltage sensor. It can include a primary and secondary capacitor, primary and secondary capacitor can be made from the same material.

The capacitor voltage sensor can be temperature-compensated and can include a reference capacitor made of the same material as the primary capacitor in addition to the secondary capacitor. The reference capacitor can also be the second capacitor.

At least one of the first and the second sensor component can comprise a coil. Coils provide a compact design, are easy to maintain and suitable for contactless sensing of, for example changes in magnetic fields.

The second sensor component can comprise a voltage sensor, a magnetic field sensor or a magnetic discharge sensor.

In another advantageous embodiment, the sensor assembly may comprise a high voltage side facing the switchgear, a low voltage side, an isolation barrier that provides a galvanic isolation between the high voltage side and the low voltage side and may further comprise a sensor subassembly that comprises a first sensor component on the high voltage side and a second sensor component on the low voltage side. The first and the second sensor component may be configured to cooperatively measure at least one physical quantity across the isolation barrier. The second sensor component can be configured to output sensor assembly data representative of the at least one physical quantity. Additionally, the sensor assembly may comprise a data interface arranged on the low voltage side and configured to provide for sensor data to be accessible from outside of the sensor assembly, which allows for remote accessing of obtained data and the possibility to react quickly to deviations in data. The sensor assembly may also comprise a transmission path which is configured to transmit sensor data from the second sensor component device to the output interface.

The second sensor component may be configured to output data periodically, which allows the sensor assembly to conserve power by activating the communication at set intervals. This also reduces the overall data load, increases the predictability of data income and simplifies data processing. The second sensor component may also be configured to output data continuously, which has the advantage of real time monitoring and a faster response to anomalies.

Furthermore, the first sensor component may be a passive sensor component and the second sensor component may be an active sensor component.

The first sensor component may be configured to be mounted on a switchgear lug to directly monitor physical quantities of the lug, such as the temperature. The switchgear lug may correspond to a busbar. The sensor device may be configured to be mounted on a busbar.

The first sensor component can be installed in the switchgear connector before the back plug. Particularly, the first sensor component can be a part of a magnetic field sensor that is positioned in an exact position in the switchgear connector, since the magnetic field sensor requires a correct alignment within the connector.

Furthermore, the sensor assembly can comprise a sensor device configured to measure at least one further physical quantity and output sensor device data representative of the at least one further physical quantity. The sensor device can be arranged on the high voltage side and the transmission path may connect the sensor device to the data interface and may comprise a wireless section which extends across the isolation barrier.

The sensor device may comprise an active sensor and/or a passive sensor. The passive sensor has the advantage of a low power consumption and a reduced complexity in comparison to active sensors. The usage of passive sensors reduces the costs.

The sensor assembly may comprise a first near field communication device on the high voltage side and a second near field communication device on the low voltage side, wherein the wireless section extends between the first and the second near field communication device.

The first and/or second near field communication device is configured to conform to NFC standard. Using the NFC standard enables short-range and contactless communication while providing quick data transfers. NFC devices can operate in both read and write modes, allowing for a bidirectional communication. They also have the advantage of not disturbing the isolation barrier between the high voltage side and the low voltage side.

The wireless section may end at the first and second near field communication device, respectively. The wireless section may be configured to transmit power from the data interface to the sensor device, making power cables negligible. The transmission path may be configured to transmit power to the second sensor component and/or the sensor device.

The transmission path may comprise at least one mechanically separable electrical connection located in the high voltage side. The connection may be between mating electrical connectors. The connection may also comprise slip rings, which allow for an uninterrupted transmission while also allowing continuous rotation, such as screwing in the back plug or a component of the sensor assembly into the switchgear connector.

Another embodiment may be a back plug that contains the low voltage side and isolation barrier of the sensor assembly. The back plug may comprise a housing that receives the low voltage side and the isolation barrier. The remainder of the sensor assembly may be outside the back plug.

Furthermore, the first near field communication device may be contained in the back plug. The remainder of the sensor assembly may be outside of the back plug. The high voltage side of the sensor assembly may be contained in the back plug. This is especially advantageous for the position sensitive magnetic field sensor, since one can ensure the ideal alignment with the installation of the back plug before adding the less sensitive components of the sensor assembly to the switchgear connector.

Another embodiment of the invention may be a set that comprises a back plug and a sensor unit configured to be mounted on a switchgear lug on the high voltage side. The sensor unit may comprise at least one of the sensor device and the first sensor component. The sensor unit may comprise the first near field communication device. The sensor unit may further comprise part of the mechanically separable electric connection, such as a part of the slip ring.

The set may be configured as a retrofit set, which improves the efficiency of switching out or upgrading the sensors within a set and allows for a quick installation.

The sensor unit may comprise the first near field communication device and the back plug may comprise the second near field communication device, allowing for the wireless transmission between the two parts of the set.

A further embodiment is a switchgear connector that comprises the back plug or set as described above. The back plug is received exchangeably within the switchgear connector, allowing for flexibility and expandability of the assembly.

The invention shall be explained in more detail hereafter by way of example with reference to the drawings. The feature combinations illustrated in the embodiments shown by way of example can be supplemented by further features in accordance with the above statements in correspondence with the properties of the invention required for a specific application. Individual features can also be omitted in accordance with the above statements from the embodiments described if the effect of these features is of no relevance for a specific application. The same reference numerals in the drawings are always used for elements having the same function and/or the same structure.
- Fig. 1: shows a schematic sectional view of a switchgear connector; and
- Fig. 2: shows a schematic diagram of an embodiment of a sensor assembly contained in a back plug;
- Fig. 3: shows a schematic diagram of an embodiment of a sensor assembly with slip rings;
- Fig. 4: shows a schematic diagram of an embodiment of a sensor assembly with two locally separated parts of the sensor assembly;
- Fig. 5: shows a schematic diagram of a capacitive voltage sensor; and
- Fig. 6: shows a schematic view of a lug mounted sensor.

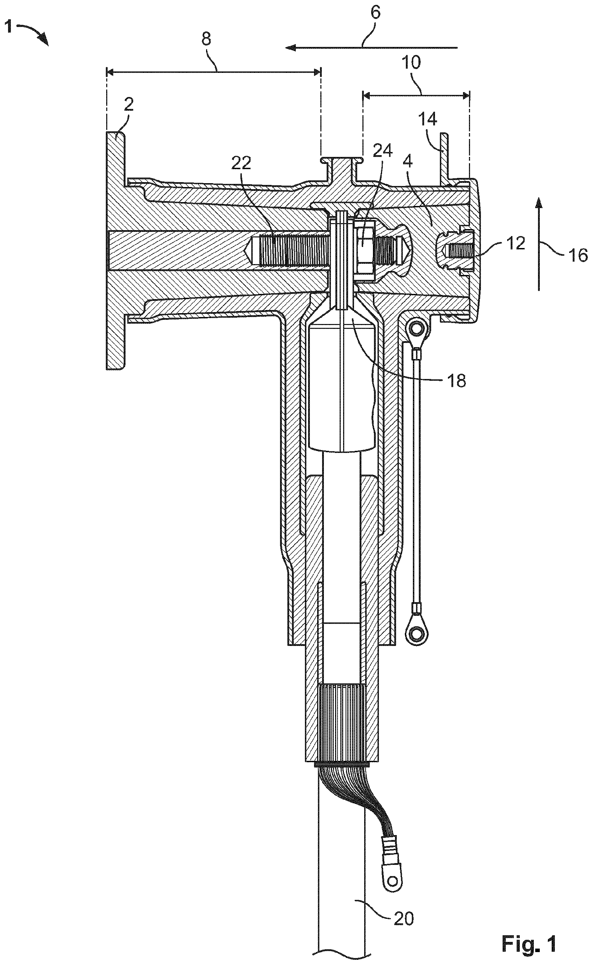

Fig. 1 shows a sectional view of a switchgear connector 1 which may be designed as an elbow connector with a horizontal or proximal part comprising a switchgear interface 2 and a back plug 4, that is inserted into the switchgear connector 1 from a side opposite the switchgear interface 2. The switchgear interface 2 is to be connected to a switchgear (not shown) in a connection direction 6, in the same direction as the installation direction of the back plug 4. The horizontal part of the switchgear connector 1 may be cylindrical, whereas the switchgear interface 2 is located on the end of the horizontal part that is located on the side further along the direction of connection 6. The back plug 4 is depicted as a truncated cone. The switchgear interface 2 reaches into the switchgear connector 1 in the direction opposite to the connection direction 6 and is designed with a greater length 8 than the length 10 of the back plug 4. In another embodiment, the switchgear interface 2 and the back plug 4 can have the same length. Alternatively, the length 10 of the back plug 4 can be longer than the length 8 of the switchgear interface 2.

The switchgear connector 1 further comprises an end cap 12 that is placed onto the switchgear connector 1 after the back plug 2 is inserted. The end cap 12 can be shaped as a circle with a slightly greater diameter than the base of the cylindrical horizontal part of the switchgear connector 1. The end cap 12 can be shaped as a lid, having a circular border protruding from the circle in the connection direction 6 and designed in a way, so that the border of the end cap 12 lies flush against the circumference of the horizontal part of the switchgear connector 1, frictionally engaging with the circumference of the horizontal part of the switchgear connector 1. The end cap 12 may further comprise a flap 14 that protrudes from the end cap 12 in any radial direction 16 and provides a touch point for users to engage, when removing the end cap 12 from the switchgear connector 1. This way, the back plug 4 may be exchanged with another back plug 4, easily upgrading or swapping out the assembly. The end cap 12 may be used for grounding sensor parts and/or as a seal to protect from dirt, water or other substances from outside the switchgear connector 1. It is also possible for one embodiment to not comprise an end cap 12 and for the back plug to seal the switchgear connector 1.

The switchgear connector 1 further comprises a vertical part perpendicular to the horizontal part of the switchgear connector 1 that extends radially from the horizontal part of the switchgear connector 1. The vertical part may also be cylindrical and is located between the switchgear interface 2 and the back plug 4 within the switchgear connector 1. The vertical part is closer located to the end cap 12 than to the outside of the switchgear interface 2.

The horizontal part and the vertical part of the switchgear connector 1 may be integral, i.e. form a unitary piece. Between the switchgear interface 2 and the back plug 4, a switchgear lug 18 is located that extends radially into the vertical part of the switchgear connector 1 and that is further connected to an electrical cable 20. The switchgear lug 18 comprises a pin or, alternatively, a threaded bolt 22 that extends in both directions of the connection direction 6, towards the switchgear interface 2 and towards the back plug 4 and that is fastened with a nut 24.

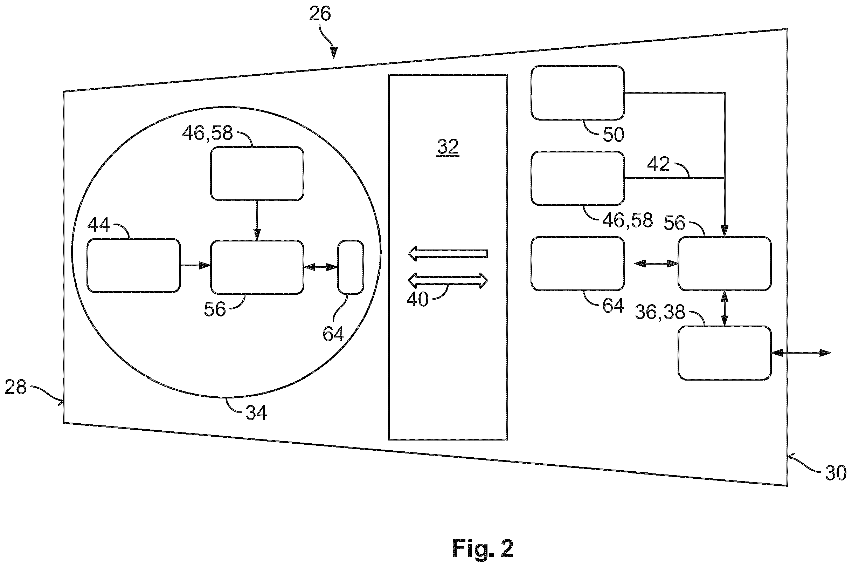

Fig. 2 shows a schematic diagram of a sensor assembly 26 that comprises a high voltage side 28 facing the switchgear (not shown) and a low voltage side 30 on the opposite side. The sensor assembly 26 may be contained in the back plug 4. The sensor assembly 26 further comprises an isolation barrier 32 that electrically isolates the high voltage side 28 from the low voltage side 30. In fig. 2, a sensor device 34 of the sensor assembly 26 is shown that may include at least one sensor to measure a physical quantity. The sensor device 34 is located on the high voltage side 28.

The sensor assembly 26 further comprises a data interface 36 that is located on the low voltage side 30. The data interface 36 may comprise or consist of a field bus interface 38 that connects to an external data processing device (not shown) and provides the sensor data 40 of the sensor device 34 to the external data processing device. The data interface 36 may also be a digital data interface. The sensor data 40 can be provided via wire. The sensor data 40 may be provided wireless. The data interface 36 may comprise wires and/or connectors to connect to the external data processing device. Alternatively, the data interface 36 can be an interface connecting via Bluetooth or Ethernet. The data interface 36 may also be used as an input interface to input programming, configurations and/or settings to the sensor assembly 26.

In this embodiment, the sensor assembly 26 also comprises a transmission path 42. This transmission path 42 may be located inside the isolation barrier 32. The transmission path 42 may be used to transfer sensor device data 40 between the sensor device 34 and the data interface 36. That way, the data 40 obtained by the at least one sensor of the sensor device 34 can be transferred to the data interface 36, while configuration input by a user can be transferred from the data interface 36 to the sensor device 34, enabling bidirectional data transmission.

The transmission path 42 may comprise a wireless section within the isolation barrier 32. The transmission path 42 may also be used to transmit power from the data interface 36 to the sensor device 34.

The sensor device 34 may comprise a temperature sensor 44 to measure temperature within the switchgear connector 1. The sensor device may also include a capacitive voltage sensor 46. Alternatively or cumulatively, the sensor device 34 may include at least one magnetic field sensor 48, a partial discharge sensor 50, a humidity sensor, an air pressure sensor or a line frequency sensor. The transmission path 42 connects any of the sensors to the data interface 36.

The capacitive voltage sensor 46 may include a primary and secondary capacitor 52, 54, while the primary capacitor 52, or the passive part 52 of the capacitive voltage sensor 46, is located on the high voltage side 28 and the secondary capacitor 54, or the active part 54 of the capacitive voltage sensor 46, is located on the low voltage side 30. The isolation barrier 32 may be between the primary capacitor 52 and the secondary capacitor 54. In another embodiment, the isolation barrier 43 may also be part of the primary capacitor 52. The capacitive voltage sensor 46 may comprise a microcontroller 56 that uses the sensor device data 40, especially sensed by the temperature sensor 44, to execute a temperature correction for temperature compensation.

The combination of the capacitive voltage sensor 46 with the primary capacitor 52 and the secondary capacitor 54, the isolation barrier 32 and the microcontroller 56 as mentioned above may be a sensor subassembly 58, wherein the first sensor component 60 is located on the high voltage side 28 and the second sensor component 62 is located on the low voltage side 30 and wherein the first sensor component 60 and the second sensor component 62 measure one more physical quantity across the isolation barrier 32. The second sensor component 62 is connected to the transmission path 42 and outputs second sensor data 40. The transmission path 42 may also be used to transmit power from the data interface 36 to the second sensor component. One or both of the sensor components 60, 62 may comprise a coil and may be used to measure a magnetic field. The first sensor component 60 can be a passive sensor component and the second sensor component 62 can be active sensor component.

The first capacitor 52 and the second capacitor 54 can be made from the same material. The sensor subassembly 58 may include a reference capacitor 72 made of the same material as the primary capacitor 54 for higher accuracy and temperature measurements.

The sensor assembly 26 may comprise a voltage sensor 46, or part of a voltage sensor 46, at least one magnetic field sensor 48 to measure the current, and/or a partial discharge sensor 50. The sensors may be located on the low voltage side 30. The sensor assembly 26 may further comprise a data interface 36 on the low voltage side 30 to provide sensor data 40 and may further comprise a transmission path 42 that transmits the sensor data 40 from the second sensor component 62 to the output interface 36.

The second sensor component 62 can be configured to periodically output the data 40 for an efficient energy management. The data 40 can be configured to be output continuously for real-time monitoring.

The sensor assembly 26 may further comprise a first near field communication device 64 on the high voltage side 28. Another near field communication device 64 may be located on the low voltage side 30 with the isolation barrier 32 between the near field communication devices 64. The wireless communication and transmission happens between the two near field communication devices 64 across the isolation barrier 32. At least one of the near field communication devices 64 can be standardised under NFC standard. The wireless section may end at the first and the second near field communication device 64.

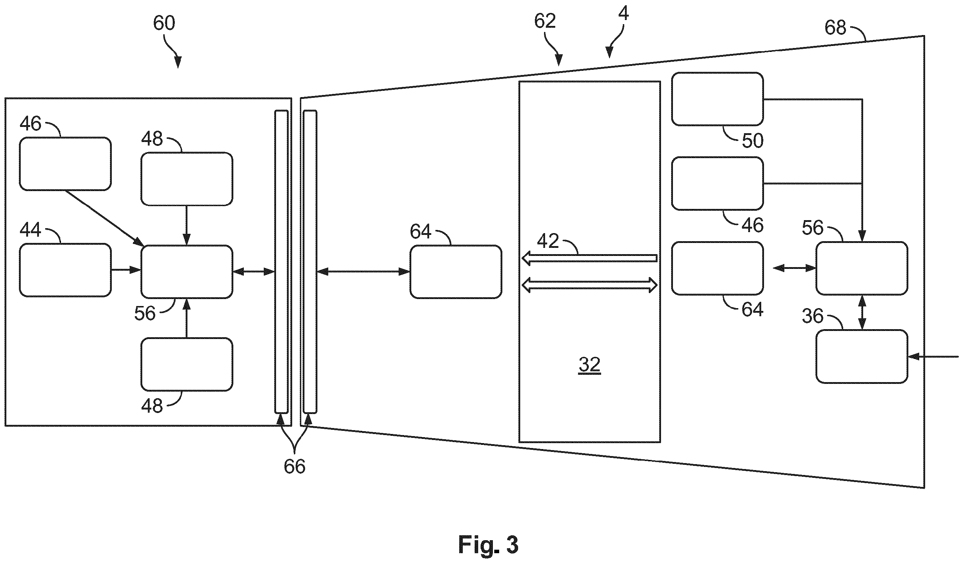

Fig. 3 shows another embodiment of the sensor assembly 26 where the first sensor component 60 is configured to be mounted on a switchgear lug 18. The switchgear lug 18 may comprise or consist of a busbar. The sensor device 34 or the first sensor component 60 may be configured to be mounted on a busbar.

The first sensor component 60 may comprise at least one, here two, magnetic field sensors 48 and a temperature sensor 44. The passive part of the voltage sensor 46 may also be located in the first sensor component 60. The sensors may be connected to a microcontroller 56. The components mentioned may be contained within one location, like a housing. They may also be directly mounted on the switchgear lug 18.

The first sensor component 60 may be installed in the switchgear connector 1 before the back plug 4. This is advantageous for the precise alignment of the first sensor component 60, as magnetic field sensors 48 are very position sensitive.

The first sensor component 60 and the back plug 4 may be connected through a mechanically separable electrical connection 66 on the high voltage side 28. In this embodiment, the mechanically separable electrical connection 66 connects the near field communication device 64 of the high voltage side 28 to the sensor component 60 of the high voltage side 28. The mechanically separable electrical connection 66 may be slip rings or electrical connectors that are mated. One part of the mechanically separable electrical connection 66 may be contained in the back plug, while the other may be located within the first sensor component 60.

The isolation barrier 32 is preferably located within the back plug 4. The first near field communication device 64 of the high voltage side 28 may be located in the back plug 4. The first near field communication device 64 may be arranged closely to the isolation barrier 32 and may be connected via the transmission path 42 and the mechanically separable electrical connection 66 to the first sensor component 60.

The back plug 4 may contain the second sensor component 62 and the low voltage side 30, the second near field communication device 64 and the data interface 36. The data interface 36 may be used to output the sensor data 40 to an external data processing device.

The back plug 4 may comprise a housing 68. The housing 68 may contain the low voltage side 28 and the isolation barrier 32, while the rest of the sensor assembly 26 can be outside of the back plug 4.

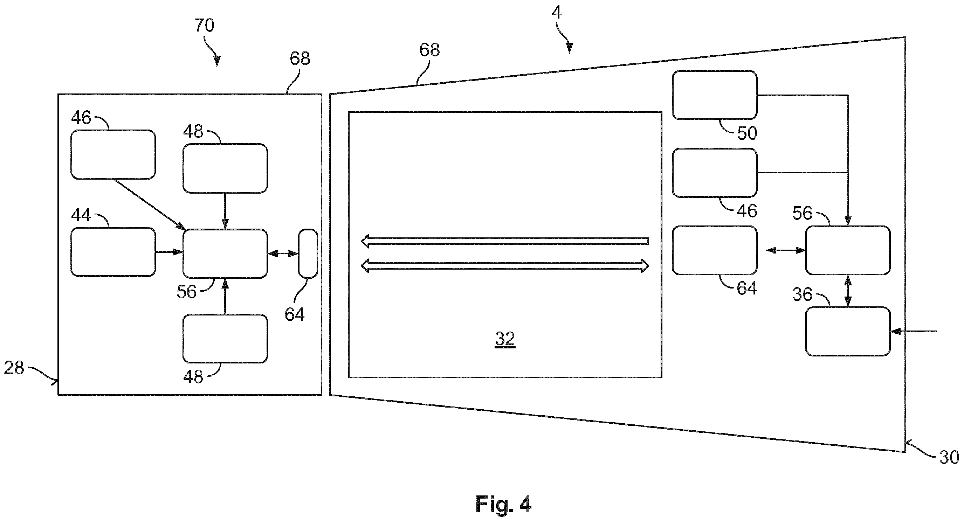

Fig. 4 shows another embodiment, wherein the high voltage side 28 and the low voltage side 30 are physically separated, for example contained in two different housings 68. On the high voltage side 28 the sensor assembly 26 may comprise a microcontroller 56 that obtains sensor data 40 of different sensors.

In this embodiment, the high voltage side 28 comprises a temperature sensor 44, two magnetic field sensors 48 and the passive part of the voltage sensor 46. It is also conceivable to add or switch the sensors to a humidity sensor, a line frequency sensor and/or a partial discharge sensor.

The high voltage side 28 may further comprise the first near field communication device 64 that is connected to the microcontroller 56 and located on the side facing the back plug 4. The first near field communication device 64 may communicate wirelessly across the isolation barrier 32 with the second near field communication device 64 that may be contained in the back plug 4 and that is located on the low voltage side 30 of the sensor assembly 26.

The back plug 4 may contain the isolation barrier 32 that provides a galvanic isolation between the high voltage side 28 and the low voltage side 30. The second near field communication device 64 can be located close to the isolation barrier 32 in the direction of connection 6, enabling the sending and receiving data to the first near field communication device 64. The second near field communication device 64 may be connected to a microcontroller 56. This microcontroller 56 obtains data 40 from a partial discharge sensor 50 and an active part of the voltage sensor 46 and further communicates with a data interface 36 that may be connected externally to another device or interface to provide sensor data 40.

In another embodiment, the high voltage side 28 of the sensor assembly 26 is completely contained in the back plug 4.

Another embodiment of the invention is a set for switchgear connector 1 that comprises the back plug 4 and a sensor unit 70 that may be mounted on a switchgear lug 18 on the high voltage side 28. The sensor unit 70 may comprise the sensor device 34 and the first sensor component 60. The sensor unit 70 may comprise only one of the sensor device 34 or the first sensor component 60. It is also possible for the sensor unit 70 to comprise the first near field communication device 64. In that case, the back plug 4 may comprise the second near field communication device 64. The sensor unit 70 may be connected via the mechanically separable electrical connection 66 and may contain a part of the mechanically separable electrical connection 66, while the back plug 4 may contain the other part of the mechanically separable electrical connection 66. The embodiment may be a retrofit set and may be used to upgrade any sensors or components.

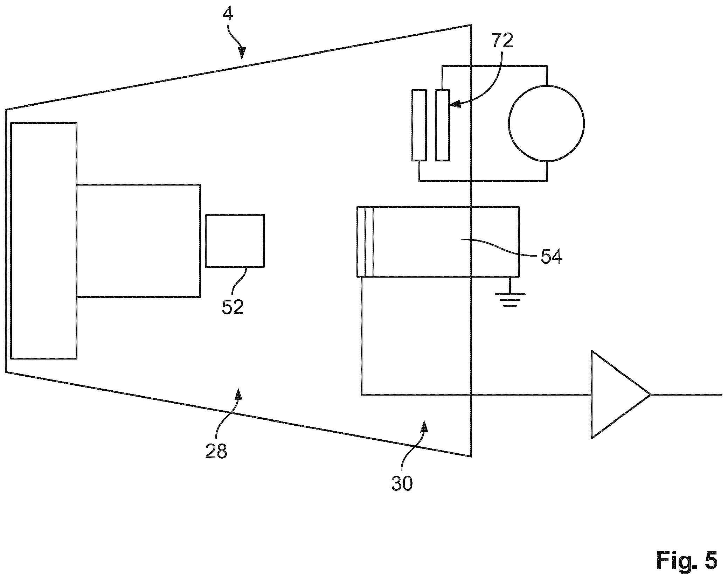

Fig. 5 shows a schematic diagram of the capacitive voltage sensor 46, which may comprise an active voltage divider that may use an amplifier to measure very low signals. The capacitive voltage sensor 46 may comprise a capacitive divider with the primary capacitor 52 and the secondary capacitor 54 connected in series. The primary capacitor 52 is located on the high voltage side 28. The secondary capacitor 54 is located on the low voltage side 30. With this combination, the capacitive voltage sensor 46 does not need an active part on the high voltage side 28. The primary capacitor 52 and the secondary capacitor 54 may be formed by the same dielectric and located close to each other to achieve a high accuracy in sensing. The secondary capacitor 54 may alternatively or cumulatively have a reference capacitor 72 that is formed by the same material as the primary capacitor 54 that can be used for temperature compensation. The secondary capacitor 54 may also be formed of a different material than the primary capacitor 54. In particular, the secondary capacitor 54 may be manufactured from commercially available components. The voltage sensor 46 may also use a component of the sensor data representative of temperature for temperature compensation.

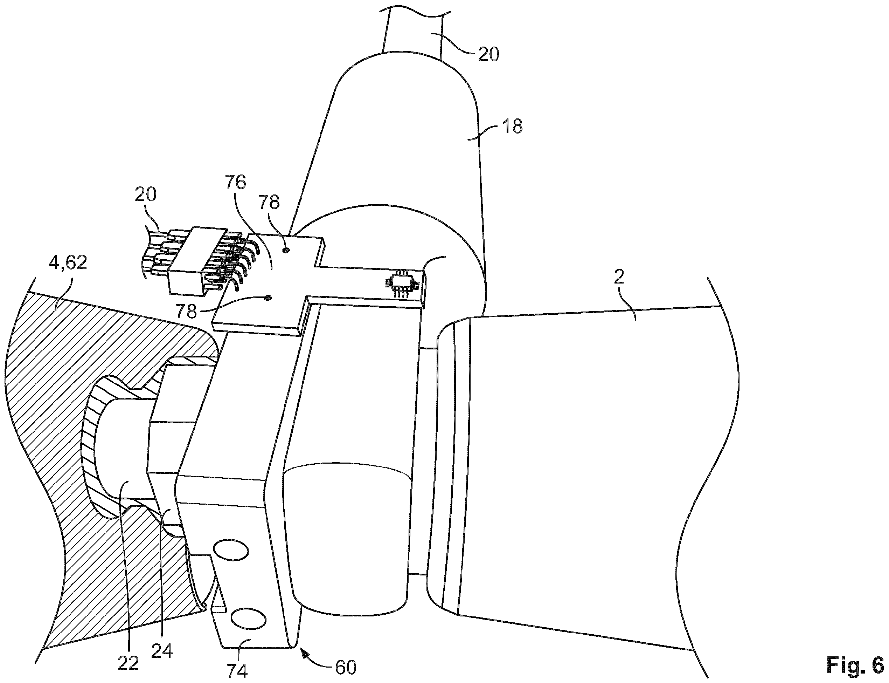

In Fig. 6, the switchgear connector 1 is shown with a switchgear lug 18 and a back plug 4. In this embodiment, the sensor assembly 26 comprises two parts, for example the first sensor component 60 and the second sensor component 62. While one part, such as the second sensor component 62, may be contained in the back plug 4, the other part may be the first sensor component 60 configured to be mounted on the switchgear lug 18.

The first sensor component 60 may comprise a mounting plate 74, where at least one sensor 76, for example a temperature sensor 44, may be attached to the mounting plate 74 and wherein the at least one sensor 76 protrudes in the direction of connection 6 in a way that allows the sensor 76 to be close enough and/or touch the switchgear lug 18 to measure a physical quantity on the switchgear lug 18.

The first sensor component 60 may also comprise of two or more sensors 76. The two or more sensors 76 may comprise at least one magnetic field sensors 48 configured to measure the magnetic field to determine the current.

The mounting plate 74 may comprise a mounting hole through which the threaded bolt 22 may be fed through to attach the mounting plate 74 to the switchgear lug 18. The nut 24 may then be used to fix the mounting plate 74 to the switchgear lug 18. The sensor 76 may be fastened to the mounting plate via screws 78 or other fasteners.

### REFERENCE NUMERALS

- 1: switchgear connector
- 2: switchgear interface
- 4: back plug
- 6: connection direction
- 8: length of the switchgear interface
- 10: length of the back plug
- 12: end cap
- 14: flap
- 16: radial direction with respect to the end cap
- 18: switchgear lug
- 20: cable
- 22: pin, threaded bolt
- 24: nut
- 26: sensor assembly
- 28: high voltage side
- 30: low voltage side
- 32: isolation barrier
- 34: sensor device
- 36: data interface
- 38: field bus interface
- 40: sensor data
- 42: transmission path
- 44: temperature sensor
- 46: voltage sensor
- 48: magnetic field sensor
- 50: partial discharge sensor
- 52: primary capacitor
- 54: secondary capacitor
- 56: microcontroller
- 58: sensor subassembly
- 60: first sensor component
- 62: second sensor component
- 64: near field communication device
- 66: mechanically separable electrical connection
- 68: housing of the back plug
- 70: sensor unit
- 72: reference capacitor
- 74: mounting plate
- 76: sensor
- 78: screw

## Claims

1. Sensor assembly (26) for a switchgear connector (1), the sensor assembly (26) comprising:
a high voltage side (28) facing the switchgear;
a low voltage side (30);
an isolation barrier (32) that provides a galvanic isolation between the high voltage side (28) and the low voltage side (30);
a sensor device (34) configured to measure at least one physical quantity and a sensor data output device representative of the at least one physical quantity,
the sensor device (34) being arranged on the high voltage side (28);
a data interface (36) arranged on the low voltage side (30) and configured to provide for the sensor device data (40) to be accessible from outside of the sensor assembly (26); and
a transmission path (42) which is configured to transfer sensor device data (40) between the sensor device (34) and the output interface (36);
wherein the transmission path (42) comprises a wireless section which extends across the isolation barrier (32).

2. Sensor assembly (26) according to claim 1, wherein
the sensor assembly (26) comprises a sensor subassembly (58), wherein the sensor subassembly (58) comprises
a first sensor component (60) on the high voltage side (28) and
a second sensor component (62) on the low voltage side (30),
the first (60) and the second sensor component (62) being configured to cooperatively measure at least one further physical quantity
the second sensor component (62) being connected to the transmission path (42) and configured to output second sensor data (40) representative of the at least one further physical quantity.

3. Sensor assembly (26) for a switchgear connector (1), the sensor assembly (26) comprising:
a high voltage side (28) facing the switchgear;
a low voltage side (30);
an isolation barrier (32) that provides a galvanic isolation between the high voltage side (28) and the low voltage side (30);
a sensor subassembly (58), the sensor subassembly (58) comprising:
a first sensor component (60) on the high voltage side (28) and
a second sensor component (62) on the low voltage side (30),
the first and the second sensor component being configured to cooperatively measure at least one physical quantity across the isolation barrier (32),
the second sensor component (62) being configured to output sensor assembly data (40) representative of the at least one physical quantity;
a data interface (36)
arranged on the low voltage side (30),
configured to provide for sensor data (40) to be accessible from outside of the sensor assembly (26); and
a transmission path (42), which is configured to transmit sensor data (40) from the second sensor component (62) to the output interface (36).

4. Sensor assembly (26) according to claim 2 or 3,
wherein the first sensor component (60) is a passive sensor component and the second sensor component (62) is an active sensor component.

5. Sensor assembly (26) according to any one of claims 2 to 4,
wherein the first sensor component (60) is configured to be mounted on a switchgear lug (18).

6. Sensor assembly (26) according to any one of claims 3 to 5,
wherein the sensor assembly (26) comprises:
a sensor device (34) configured to measure at least one further physical quantity and output sensor device data (40) representative of the at least one further physical quantity,
the sensor device (34) being arranged on the high voltage side (28);
wherein the transmission path (42) further connects the sensor device (34) to the data interface (36) and comprises a wireless section which extends across the isolation barrier (32).

7. Sensor assembly (26) according to claim 1 or 2, or according to claim 6,
wherein the sensor assembly (26) comprises a first near field communication device (64) on the high voltage side (28) and a second near field communication device (64) on the low voltage side (30), and
wherein the wireless section extends between the first and the second near field communication device (64).

8. Sensor assembly (26) according to claim 1 or 2, or according to claim 6 or 7,
wherein the wireless section is configured to transmit power from the data interface (36) to the sensor device (34).

9. Sensor assembly (26) according to any one of claims 1 to 8,
wherein the transmission path (42) comprises at least one mechanically separable electrical connection (66) located on the high voltage side (28).

10. Back plug (4) for a switchgear connector (1),
containing the low voltage side (28) and the isolation barrier (32) of the sensor assembly (26) according to any one of claims 1 to 9.

11. Back plug (4) according to claim 10,
wherein the sensor assembly (26) is configured according to claim 7, and
wherein the first near field communication device (64) is contained in the back plug (4).

12. Back plug (4) according to claim 10 or 11,
wherein the high voltage side (28) of the sensor assembly (26) according to any one of claims 1 to 9 is contained in the back plug (4).

13. Set for a switchgear connector (1),
the set comprising:
a back plug (4) according to any one of claims 10 to 12,
a sensor unit (70) configured to be mounted on a switchgear lug (18) on the high voltage side (28).

14. Set for a switchgear connector (1) according to claim 13, wherein the sensor unit (70) comprises the first near field communication device (64) and the back plug (4) comprises the second near field communication device (64).

15. Switchgear connector (1),
comprising a back plug (4) according to any one of claims 10 to 12 or a set according to claim 13 or 14.
